# EUROPEAN PATENT SPECIFICATION

(11) **EP 3 389 007 B1**
(45) Date of publication and mention of the grant of the patent: **10.06.2020**
(21) Application number: 15910178.1
(22) Date of filing: 07.12.2015
(51) Int. Cl.: G06T 7/00, G06T 1/00, H05K 13/04, G06T 7/73

(54) **SUBSTRATE IMAGE PROCESSING DEVICE AND SUBSTRATE IMAGE PROCESSING METHOD**
SUBSTRATBILDVERARBEITUNGSVORRICHTUNG UND SUBSTRATBILDVERARBEITUNGSVERFAHREN
DISPOSITIF DE TRAITEMENT D'IMAGES DE SUBSTRAT ET PROCÉDÉ DE TRAITEMENT D'IMAGES DE SUBSTRAT

(43) Date of publication of application: 17.10.2018
(73) Proprietor: Fuji Corporation, Chiryu-shi, Aichi 472-8686 (JP)
(72) Inventor: TERAOKA Seiichi, Chiryu Aichi (JP)
(74) Representative: Grünecker Patent- und Rechtsanwälte PartG mbB
(86) International application number: PCT/JP2015/084303
(87) International publication number: WO 2017/098561

(56) References cited:
- EP-A1- 3 376 844
- JP-A- 2002 157 582
- JP-A- 2005 116 561
- JP-A- 2005 116 561
- JP-A- 2006 129 425
- US-B2- 8 538 168

## Description

### Technical Field

The present invention relates to an image processing device and an image processing method for a board.

### Background Art

Patent Document 1 discloses a configuration for recognizing a reference position of a board carried into a component mounting machine. In the recognition of the reference position of the board, for example, a distinctive portion in the wiring pattern is detected as a fiducial marker from image data obtained by capturing an image of the wiring pattern of the board. Further, in the above detection operation, a template showing the distinctive portion in the wiring pattern is used similar to a reference line having a shape conforming to the edge of the distinctive portion or a plurality of seek lines intersecting the edge.

Patent Document 1, Patent Document 2 and Patent Document 3 provide further image processing devices according to the prior art.

### Prior art literature

Patent Document 1: Japanese Unexamined Patent Application Publication No. 2003-086996
Patent Document 2: JP 2005116561 A
Patent Document 3: US 8538168 B2
Patent Document 4: EP 3376844 A1

### BRIEF SUMMARY OF THE INVENTION

### Technical Problem

When the distinctive portion of the wiring pattern is not detected in the above detection operation, the image processing device displays the image data to the operator, and complements the detection process by receiving a setting of the reference position in the image data. However, the setting of the reference position by manual operation of the operator may include an error due to visual measurement. In order to adequately maintain accuracy of a mounting process of the component mounting machine, it is desirable to recognize the reference position of the board with high accuracy.

It is an object of the present invention to provide an image processing device and an image processing method for a board capable of recognizing a reference position of a board with higher accuracy.

### Solution to Problem

The image processing device for a board and the image processing method for a board are defined in the appended claims.

### Advantageous Effects of Invention

According to the configuration of the invention of claims 1 and 5, when the position of the fiducial mark of the board cannot be detected, the reference position of the board is recognized by using the second template which shows other distinguishing portions included in the first region. Thus, the complementary procedure using the second template can be executed, and the reference position can be recognized with higher accuracy than the case where the reference position of the board is set by the manual operation of the operator. Further, the image data acquired in the initial detection process using the first template can be redirected, the processing efficiency in the image processing can be improved, and the time required for a complementary process can be shortened.

### Brief Description of Drawings

FIG. 1 is a schematic diagram showing a production line to which an image processing device for a board according to a first embodiment is applied.
FIG. 2 is a diagram illustrating a board, a wiring pattern, and a first region.
FIG. 3 is a diagram illustrating a state in which a first template is superimposed on image data obtained by imaging the first region in FIG. 2.
FIG. 4 is a flowchart showing an image process for recognizing a reference position of a board.
FIG. 5 is a flowchart showing a complementary process of FIG. 4.
FIG. 6 is a diagram showing a generated second template.
FIG. 7 is a diagram showing a state in which first image data is divided into a plurality of sections.
FIG. 8 is a diagram showing a screen of a display device in which the second template is superimposed on the image data and displayed, and in which alignment of the second template with the image data by manual operation of the operator is accepted.
FIG. 9 is a flowchart showing a complementary process of a second embodiment.

### DESCRIPTION OF EMBODIMENTS

Hereinafter, an image processing device and an image processing method for a board according to an embodiment of the present invention will be described with reference to the drawings. The embodiment is an example of a configuration in which an image processing device for a board is incorporated in a component mounting machine constituting a production line for manufacturing a circuit board product such as an integrated circuit.

### First Embodiment

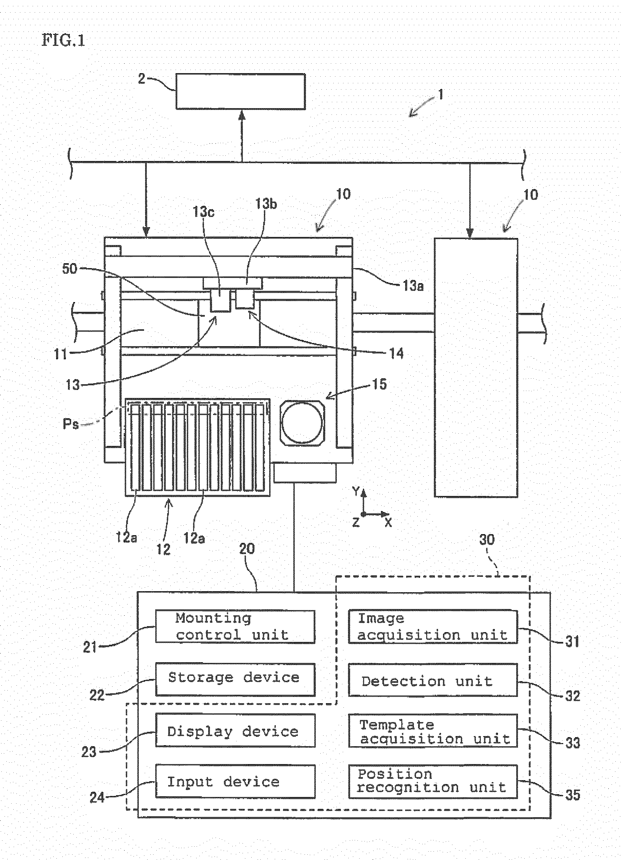

As shown in FIG. 1, the production line 1 is composed of multiple production devices that are communicably connected to a host computer 2 via a network. In addition to the component mounting machine 10, the production device includes, for example, a screen printing machine, a mounting inspection machine, a reflow furnace, and the like. The production device that includes the component mounting machine 10 is configured to be capable of inputting and outputting various data to and from the host computer 2 via the network.

The host computer 2 monitors the operating state of the production line 1 and controls production devices which include the component mounting machine 10. The host computer 2 stores various data for controlling the component mounting machine 10. The various data described above includes a production plan, which includes the type and production volume of the circuit board product to be produced, a control program for operating the component mounting machine 10, and a template used for image processing. The host computer 2 appropriately sends various data, such as the control program, to each production device when a production process is executed at each production device.

### (Configuration of the component mounting machine 10)

As shown in FIG. 1, a plurality of component mounting machines 10 constituting the production line 1 include a board conveyance device 11, a component supply device 12, a component transfer device 13, a component camera 14, a board camera 15, and a control device 20. In the following description, the horizontal width direction (i.e., the left-right direction in FIG. 1) of the component mounting machine 10 is defined as the X-axis direction, the horizontal depth direction (i.e., the up-down direction in FIG. 1) of the component mounting machine 10 is defined as the Y-axis direction, and the vertical direction (i.e., the front-rear direction in FIG. 1) perpendicular to the X-axis and the Y-axis is defined as the Z-axis direction.

The board conveyance device 11 is composed of a belt conveyor or the like, and sequentially conveys the board 50 in the conveyance direction (i.e, the X-axis direction in the present embodiment). The board conveyance device 11 positions the board 50 at a predetermined position in the component mounting machine 10. After a mounting process is executed by the component mounting machine 10, the board conveyance device 11 carries the board 50 out of the component mounting machine 10.

The component supply device 12 supplies electronic components to be mounted on the board 50 at a supply position Ps. The component supply device 12 has a plurality of slots arranged side by side in the X-axis direction. A feeder 12a is detachably set in each of the plurality of slots. The component supply device 12 feeds and moves, for example, a carrier tape with the feeder 12a and supplies electronic components at a retrieval portion located on the edge (i.e., the upper portion in FIG. 1) of the feeder 12a.

The component transfer device 13 is configured to be movable in the X-axis direction and the Y-axis direction. The component transfer device 13 is arranged from the rear (i.e., the upper side in FIG. 1) in the depth direction of the component mounting machine 10 to the top of the component supply device 12 at the front of the component mounting machine 10. The component transfer device 13 is provided with a head driving device 13a, a moving table 13b, and a mounting head 13c. The head driving device 13a is configured so that the moving table 13b can be moved in the XY-axis direction by a linear motion mechanism.

The mounting head 13c is clamped and fixed to the moving table 13b via a frame (not shown). A plurality of suction nozzles (not shown) are detachably provided on the mounting head 13c. The mounting head 13c supports each suction nozzle so as to be rotatable about an R-axis parallel to the Z-axis and capable of ascending and descending. Each suction nozzle is controlled in its elevation position and angle with respect to the mounting head 13c, and negative pressure supply state. Each suction nozzle draws in and holds an electronic component supplied at the retrieval portion of the feeder 12a by being supplied with negative pressure.

The component camera 14 and the board camera 15 are digital imaging devices each having an imaging device such as a CCD (Charge Coupled Device) or a CMOS (Complementary Metal Oxide Semiconductor). The component camera 14 and the board camera 15 perform imaging in a range within the camera field of view based on a control signal from the communicably connected control device 20 and transmit the image data acquired by the imaging to the control device 20.

The component camera 14 is fixed to the base of the component mounting machine 10 such that the optical axis is directed upward in the vertical direction (i.e., in the Z-axis direction) and is configured to capture an image from below the component transfer device 13. More specifically, the component camera 14 is configured to capture an image of the lower surface of the electronic component held by the suction nozzle. The board camera 15 is provided on the moving table 13b of the component transfer device 13 so that the optical axis is directed downward in the vertical direction (i.e., the Z-axis direction). The board camera 15 is configured to capture an image of the board 50.

The control device 20 is mainly composed of a CPU, various types of memory, and a control circuit. The control device 20 controls the mounting process of the electronic component. The control device 20 is communicably connected to the host computer 2 via the network. As shown in FIG. 1, the control device 20 includes a mounting control unit 21, a storage device 22, a display device 23, an input device 24, and an image processing device 30.

The mounting control unit 21 controls the position of the mounting head 13c and operation of the suction mechanism. More specifically, the mounting control unit 21 inputs information output from a plurality of sensors provided in the component mounting machine 10 and results of various recognition processes. The mounting control unit 21 then sends a control signal to the component transfer device 13 based on the control program stored in the storage device 22, the information from the various sensors, and the result of the recognition process of the image processing device 30. As a result, the position and the rotation angle of the suction nozzle supported by the mounting head 13c are controlled.

The storage device 22 is configured by an optical drive device such as a hard disk device, a flash memory, or the like. The storage device 22 stores a control program, control information, image data, temporary data of various processes performed by the image processing device 30, and the like. The display device 23 displays various data as images to the operator. The input device 24 is a device that accepts input of various data by manual operation of the operator.

### (Configuration of the image processing device 30)

The image processing device 30 acquires image data by capturing images with the component camera 14 and the board camera 15, and executes image processing in accordance with the application. The image processing may include, for example, binarization of image data, filtering, hue extraction, super-resolution processing, and the like. The image processing device 30 executes image processing for recognizing the reference position of the board 50.

Here, a positioning error may occur in the position of the board 50 carried into the device by the board conveyance device 11. Therefore, the control device 20 corrects the position of the suction nozzle held by the mounting head 13c according to the positioning state of the board 50 based on the result of image processing for recognizing the reference position of the board 50. As a result, the electronic component is mounted at an appropriate position on the board 50 and the accuracy of the mounting process is improved.

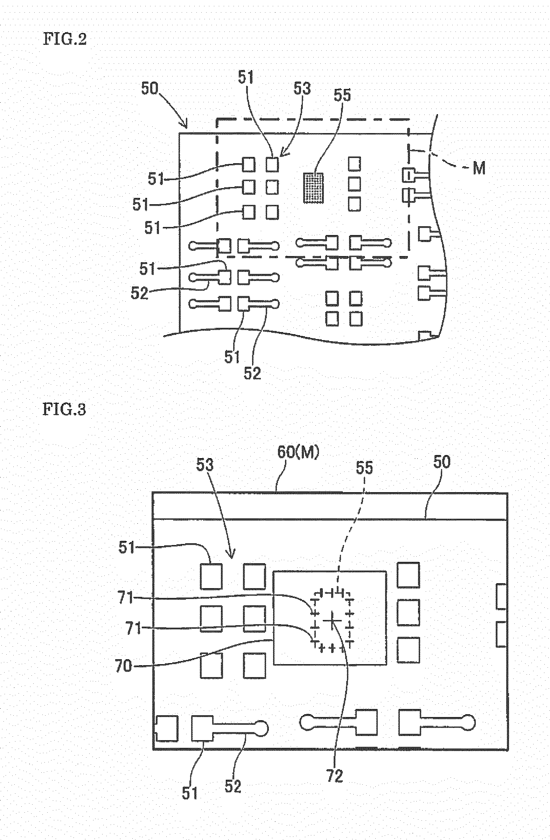

In the recognition of the reference position of the board 50 described above, an arbitrarily-shaped fiducial mark disposed on the upper surface of the board 50 is detected. In the present embodiment, as shown in FIG. 2, the image processing device 30 adopts a rectangular fiducial mark 55 (hereinafter, referred to as an "F-mark") as a fiducial mark.

As shown in FIG. 1, the image processing device 30 includes an image acquisition unit 31, a detection unit 32, a template acquisition unit 33, and a position recognition unit 35. The image acquisition unit 31 acquires image data 60 (see FIG. 3) obtained by imaging the first region M (see FIG. 2) that includes the F-mark 55, which is a fiducial mark disposed on the upper surface of the board 50. In the present embodiment, the "first region M" is a region that can be imaged by the board camera 15 that is moved relative to the board 50.

The detection unit 32 scans the image data 60 using the first template 70 that shows the shape of the F-mark 55, which is a fiducial mark, and detects the position of the F-mark 55. Here, the template used for detection, such as the first template 70, is composed of a standard line having a shape corresponding to the edge of a detection target (here, the F-mark 55) or a plurality of seek lines arranged based on the shape of the edge, and is stored in the storage device 22.

In the present embodiment, as shown in FIG. 3, the first template 70 is composed of a plurality of seek lines 71 intersecting the edge of the F-mark 55 and a defining point 72 indicating the position of the F-mark 55 when the F-mark 55 is detected. The positional relationship of the first template 70 with the reference position of the board 50 is defined by the position of the defining point 72.

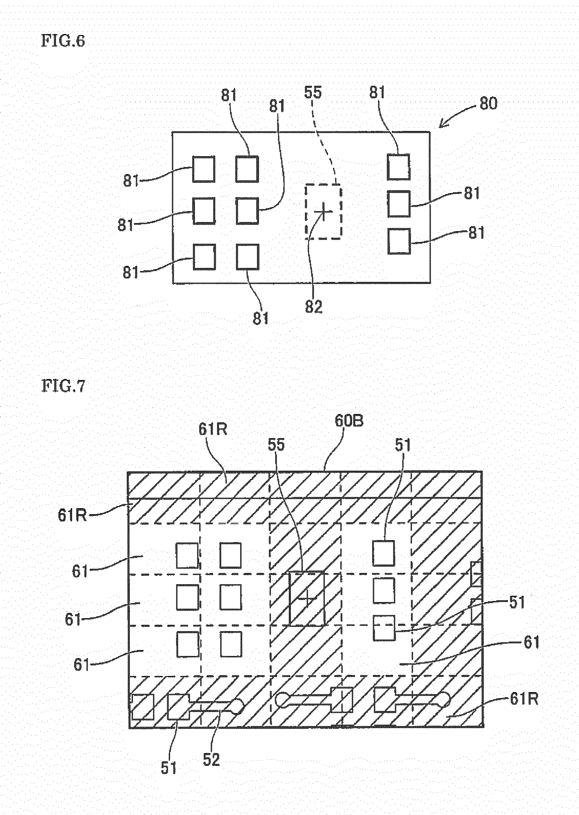

When the position of the F-mark 55 is not detected by scanning with the detection unit 32, the template acquisition unit 33 acquires a second template 80 that shows a distinctive portion 53 of the board 50 located outside the F-mark 55 in the first region M (see FIG. 6). When the position of the F-mark 55 is not detected by scanning with the first template 70 as described above, the image processing device 30 needs to recognize the reference position of the board 50 by another method. In this case, the image processing device 30 executes a complementary process that complements the detection process.

The second template 80 used in the above-described complementary process shows a distinctive portion 53 of the board 50 surrounding the F-mark 55 and at a position within the first region M. Specifically, the distinctive portion 53 of the board 50 consists of a shape, a pattern, a color, or a combination thereof formed by a wiring pattern on the upper surface of the board, printed solder, a mounted electronic component, or the like. In the present embodiment, the distinctive portion 53 of the board 50 is a characteristically-shaped wiring pattern formed on the upper surface of the board 50.

Here, as shown in FIGS. 2 and 3, the wiring pattern of the board 50 is composed of lands 51, which are applied by printing solder or the like and electrically connected to the terminals of an electronic component, and wiring portions 52, which connect the lands 51 to each other. More specifically, the distinctive portion 53 of the board 50 is constituted by a plurality of lands 51 having a rectangular-shaped positional relationship. Correspondingly, in the present embodiment, as shown in FIG. 6, the second template 80 is composed of a plurality of standard lines 81 and a defining point 82.

The plurality of standard lines 81 indicate the edges and positional relationship of the plurality of lands 51. The defining point 82 indicates the position of the F-mark 55 which is not detected when the distinctive portion 53 of the board 50 is detected. That is, similarly to the first template 70, the positional relationship of the second template 80 with the reference position of the board 50 is defined by the position of the defining point 82. Furthermore, in FIG. 6, the F-mark 55 is indicated by a broken line.

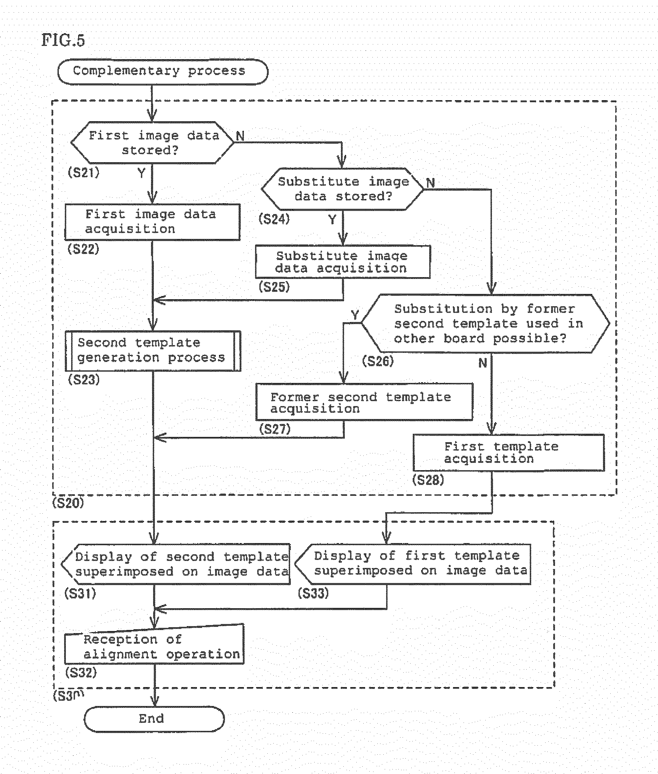

Also, as a method for the template acquisition unit 33 for acquiring the second template 80, aside from reading a spare template that is stored in the storage device 22 in advance, the second template 80 may be appropriately generated in the complementary process. Details of the method for acquiring the second template 80 will be provided in the description of the complementary process (see FIG. 5) .

The position recognition unit 35 recognizes the reference position of the board 50 based on the detection result of the F-mark 55 by scanning with the detection unit 32 using the first template 70. In the above-described complementary process, the position recognition unit 35 recognizes the reference position of the board 50 using the second template. In the present embodiment, the position recognition unit 35 accepts a setting by manual operation regarding the alignment of the second template 80 with respect to the image data 60 and recognizes the reference position of the board 50 based on the content of the setting.

Here, in the complementary process, the display device 23 of the control device 20 is also used as a display unit of the image processing device 30 for displaying the second template 80, acquired by the template acquisition unit 33, overlapped with the image data 60. Further, the input device 24 of the control device 20 also serves as a setting receiving unit that receives the setting of the relative position of the second template 80 with respect to the image data 60. In other words, when the second template 80 is aligned with the image data 60 by manual operation of the operator, the image processing device 30 recognizes the reference position of the board 50 based on the position of the defining point 82 of the second template 80.

### (Image processing by the image processing device 30)

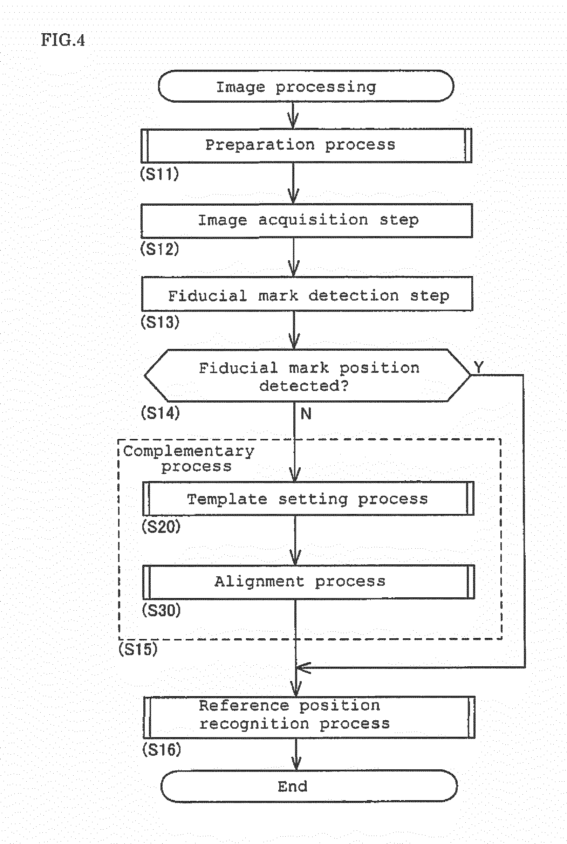

Image processing for recognizing the reference position of the board 50 by the image processing device 30 for the board will be described. Image processing is executed in order to recognize the reference position of the board 50 positioned by the board conveyance device 11, for example, in the mounting processing of the component mounting machine 10. First, as shown in FIG. 4, the image processing device 30 executes a preparation process (step 11 (hereinafter, "step" is written as "S")).

The preparation process (S11) includes an imaging process for imaging the first region M including the F-mark 55 and a process for reading, from the storage device 22, the first template 70 indicating the shape of the F-mark 55. Next, the image acquisition unit 31 acquires the image data 60 obtained by imaging the first region M stored in the storage device 22 (S12). Subsequently, the detection unit 32 scans the image data 60 using the first template 70 to detect the position of the F-mark 55 (S13).

The image processing device 30 determines whether or not the position of the F-mark 55 is detected by scanning with the detection unit 32 (S14). Specifically, when all the seek lines 71 of the first template 70 intersect the edge in the image data 60 at a predetermined position in the edge-processed image data 60, it is determined that the F-mark 55 matching the first template 70 has been detected (S14: Yes). The position recognition unit 35 then recognizes the reference position of the board 50 based on the detection result of the F-mark 55 by scanning with the detection unit 32 (S16).

On the other hand, when all the seek lines 71 do not intersect the edge in the image data 60, the image processing device 30 determines that the position of the F-mark 55 has not been detected (S14: No). In this way, when the position of the F-mark 55 is not detectable due to a factor such as a lack of a portion of the F-mark 55, the complementary process that acquires the position of the F-mark 55 is executed (S15).

In the present embodiment, the complementary process (S15) includes a setting process (S20) of the second template 80 and an alignment process (S30) of the image data 60 with the second template 80. As a result, the position of the F-mark 55 which is not detected by scanning using the first template 70 is complemented and the reference position of the board 50 can be recognized (S16).

### (Details of the complementary process)

In the template setting process (S20) of the complementary process (S15), the template acquisition unit 33 newly generates a second template 80 or acquires an existing second template 80, thereby setting the second template 80 to be used in the subsequent alignment process (S30) .

The image processing device 30 then appropriately executes the recognition process for recognizing the reference position of the board 50 during execution of the mounting process by the component mounting machine 10. For this purpose, image processing for detecting the position of the F-mark 55 may be performed a plurality of times in the mounting process for the same board 50. However, some or all portions of the F-mark 55 shape may be covered by the electronic component mounted in the mounting process, and the position of the F-mark 55 may not be detected. Therefore, when the position of the F-mark 55 is detected by scanning using the first template 70, the image processing device 30 stores the image data in the storage device 22 as "first image data 60B", in which the F-mark 55 is successfully detected during the recognition process, on the assumption that the image data used in the recognition process will be used in a later recognition process.

As shown in FIG. 5, the template acquisition unit 33 first determines whether or not the first image data 60B is stored in the storage device 22 (S21). That is, for the board which is the target of the mounting process currently being executed by the component mounting machine 10, if the recognition process of the reference position using the first template 70 has already been executed and the position of the F-mark 55 has been successfully detected in a board 50, it is determined that the first image data 60B is stored in the storage device 22 (S21: Yes).

Then, if the position of the F-mark 55 is not detected by scanning with the detection unit 32 using the first template in the second and subsequent recognition processes (S14: No in FIG. 4), the template acquisition unit 33 acquires the first image data 60B, which is the image data used in the previous recognition process in which the position of the F-mark 55 was detected (S22). Subsequently, the template acquisition unit 33 executes a generation process for generating a second template 80 by executing image processing on the first image data 60B (S23).

Here, since the second template 80 in the present embodiment is used for alignment by manual operation of the operator, image processing suitable for the alignment process is executed. Specifically, the template acquisition unit 33 executes image processing to make the first image data 60B transparent so that other image data 60 displayed with the second template 80 superimposed can be viewed. In addition to making the first image data 60B transparent, the template acquisition unit 33 may execute image processing such as edge processing or binarization so that the shape of the distinctive portion 53 of the board 50 is noticeable.

Further, in the present embodiment, in the generation process (S23) for generating the second template 80, the template acquisition unit 33 divides the first image data 60B into a plurality of sections 61, as shown in FIG. 7. Then, the template acquisition unit 33 removes sections 61R (hatched portion in FIG. 7) which satisfy a predetermined condition from the plurality of sections 61. In the present embodiment, the sections to be removed 61R include sections in which electronic components are mounted to obtain the first image data 60B from the time of imaging to the present, and sections in which the complexity of the image exceeds a predetermined threshold value.

The sections 61 in which electronic components are mounted are removed because the template including the sections 61 is unsuitable for the alignment process by visual measurement due to variation in appearance of the board 50. In addition, the sections 61 in which the complexity of the image exceeds the threshold value are removal targets because the edges are gathered together in a complex manner rendering the template including the sections 61 unsuitable for the alignment process by visual measurement.

In the present embodiment, the template acquisition unit 33 executes image processing for removing regions which include the F-mark 55 in the first image data 60B. Since the position of the F-mark 55 cannot be detected by scanning using the first template 70, the first template 70 may not be entirely visible in the image data 60 which indicates the current state of the board 50. Therefore, the template acquisition unit 33 removes the sections 61 that include the F-mark 55, which does not match with the current appearance of the second template 80, and is configured to generate a second template 80 which conforms better to the alignment process by the visual measurement.

As a result, as shown in FIG. 6, a second template 80 that shows a distinctive portion 53 of the board 50 is newly generated. Since the position of the F-mark 55 was detected in the first image data 60B, the defining point 82 of the second template 80 is defined by the result of the detection and the positional relationship of the defining point 72 of the first template 70. That is, the defining point 82 indicates the position of the F-mark 55 in the image data 60 when the second template 80 is aligned with the image data 60.

When the first image data 60B is not stored in the storage device 22 (S21: No), the template acquisition unit 33 determines whether or not substitute image data that can substitute for the first image data 60B is stored in the storage device 22 (S24). Substitute image data is, for example, image data obtained by imaging in advance a board of the same type as the board 50 to be subjected to the mounting process. If substitute image data is stored (S24: Yes), the template acquisition unit 33 acquires the substitute image data (S25). The template acquisition unit 33 then performs image processing such as making the substitute image data transparent and generates a second template 80 (S23).

On the other hand, when substitute image data is not stored in the storage device 22 (S24 : No), the template acquisition unit 33 determines whether or not substitution by the existing second template (hereinafter, referred to as the "former second template") used in the other board 50 is possible (S26). Here, the appearance of the board 50 differs depending on the mounting state of the electronic component and the printing state of the solder. Therefore, in the complementary process (S15) during execution of the mounting process, it is desirable to generate the second template 80 by using the first image data 60B obtained by imaging the target board 50.

On the other hand, in the case where the distinctive portion 53 of the board 50 includes lands 51, individual differences are sufficiently small as long as the board 50 is of the same type. Therefore, when the former second template has already been generated in the other image processing, the template acquisition unit 33 determines whether or not the former second template can be substituted based on the type of the board 50 targeted for the image processing and the imaging region of the first image data which is the material of the former second template (S26).

When it is determined that replacement with the former second template is possible (26: Yes), the template acquisition unit 33 acquires the former second template as the second template 80 in the current complementary process (S27). On the other hand, when replacement by the former second template is not possible (including the case in which the former second template is not stored) (S26 : No), the template acquisition unit 33 acquires the first template 70 (S28).

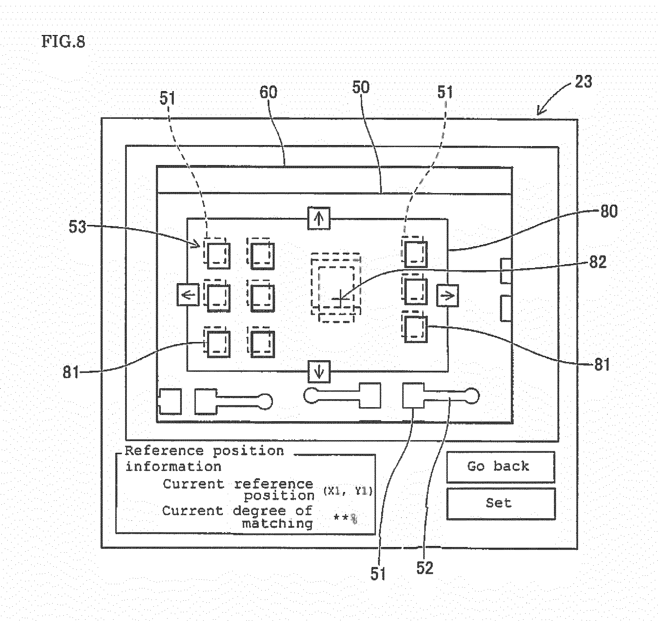

Subsequently, in the alignment process (S30), the display device 23 displays the second template 80 superimposed on the image data 60, as shown in FIG. 8 (S31). In the display device 23, for example, a cursor is arranged on each of four sides of the rectangular second template 80. Further, when the second template 80 is displayed on the image data 60 in an overlapping manner as described above, the display device 23 also displays the degree of matching based on the relative position of the second template 80 with respect to the distinctive portion 53 of the board 50.

The degree of matching between the distinctive portion 53 and the second template 80 is, for example, a value indicating how much the standard lines 81 of the second template 80 overlap with the edges in the image data 60. The display device 23 displays the degree of matching in numerical values as shown in the lower part of FIG. 8. Alternatively, the display device 23 may display the degree of matching with a display color or line type of the standard line 81 of the second template 80.

Thereafter, the input device 24 receives an operation for aligning the second template 80 with respect to the image data 60 (S32). The operator adjusts, for example, the state of overlap between the lands 51 and the standard lines 81 of the second template 80 in the image data 60 with reference to, for example, the numerical degree of matching.

If the relative position of the second template 80 with respect to the image data 60 is set by this operation, the state is the same as the case in which the position of the F-mark 55 is detected. Thereafter, the position recognition unit 35 recognizes the reference position of the board 50 based on the content of the setting and the positional relationship with the reference position defined by the defining point 82 of the second template 80 (S16).

Further, in the template setting process (S20), if the second template 80 cannot be acquired, the display device 23 displays the first template 70 superimposed on the image data 60, and the input device 24 receives an operation for aligning the first template 70 with the image data 60 (S32). After that, the position recognition unit 35 recognizes the reference position of the board 50 based on the position of the defining point 72 of the aligned first template 70 (S16).

### Second Embodiment

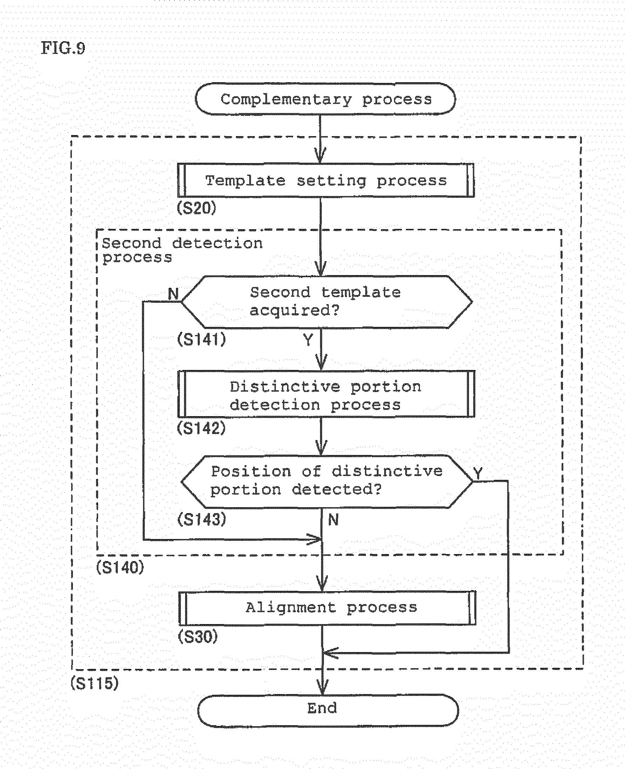

The configuration of the image processing device and the image processing method according to the second embodiment is mainly different from that of the complementary process (S15) according to the first embodiment. Other common configurations are substantially the same as those of the first embodiment, and therefore detailed description thereof will be omitted. In the second embodiment, as shown in FIG. 9, the complementary process (S115) includes a setting process (S20) of the second template 80, a second detection process (S140) of performing re-detection using the second template 80, and a alignment process (S30).

Here, since the second template 80 in the present embodiment is used for re-detection by the detection unit 32 as described above, image processing suitable for the detection process is executed. Specifically, in the generation process (S23) for generating the second template 80, the template acquisition unit 33 executes image processing for extracting an edge corresponding to the distinctive portion 53 of the board 50. Thus, the extracted edge is defined as the standard line 81 of the second template 80.

After the template acquisition unit 33 executes the template setting process (S 20) in the complementary process (S115), the image processing device 30 first determines whether or not the second template 80 has been obtained (S141). When the former second template that can be newly generated or substituted is acquired as the second template 80 (S141: Yes), the detection unit 32 scans the image data 60 using the acquired second template 80 to detect the position of the distinctive portion 53 of the board 50. That is, the detection unit 32 performs detection using the second template 80 again.

The image processing device 30 determines whether or not the position of the distinctive portion 53 of the board 50 is detected by the scanning of the detector 32 (S143). Specifically, when all the normal lines 81 of the second template 80 coincide with the edge of the image data 60 at a predetermined position in the edge-processed image data 60, it is determined that the distinctive portion 53 that matches with the second template 80 has been detected (S143: Yes). From this, the alignment process (S30) by the operator is omitted, and the complementary process (S115) is ended. Thereafter, the position recognition unit 35 recognizes the reference position of the board 50 based on the detection result for the distinctive portion 53 in the scanning by the detection unit 32 (S16).

On the other hand, when none of the standard lines 81 intersect the edges of the image data 60, the image processing device 30 determines that the position of the distinctive portion 53 is not detected (S143: No). As described above, when the position of the distinctive portion 53 corresponding to the position of the F-mark 55 cannot be detected even when the automatic re-detection process is executed, or when the second template 80 cannot be acquired in the template setting process (S20) (S141: No), the alignment process (S30) by the operator's manual operation is executed, and the complementary process (S115) is ended. After that, the position recognition unit 35 recognizes the reference position of the board 50 (S16) based on the content of the setting in the alignment process.

### Effects of the Configurations of the First and Second Embodiments

The image processing device 30 for a board includes an image acquisition unit 31 that acquires image data 60 obtained by capturing an image of a first region M that includes a fiduciary mark (F-mark 55) disposed on an upper surface of the board 50, a detection unit 32 that scans the image data 60 using a first template 70 that shows the shape of the fiduciary mark (F-mark 55) and detects the position of the fiduciary mark (F-mark 55) by scanning, and a template acquisition unit 33 that acquires a second template that shows a distinctive portion 53 of the board 50 disposed outside of the F-mark 55 in the first region M when the position of the F-mark 55 is not detected by the detection unit 32.

The image processing method for a board includes an image acquisition step (S12) of acquiring the image data 60 obtained by imaging the first region M that includes the fiduciary mark (F-mark 55) disposed on the upper surface of the board 50, a detection step (S13) of scanning the image data 60 using the first template 70 that shows the shape of the fiduciary mark (F-mark 55) and detecting the position of the fiduciary mark (F-mark 55) by scanning (S14 : No), and a template acquisition step (S20) of acquiring a second template that shows a distinctive portion 53 of the board 50 disposed outside of the fiducial mark (F-mark 55) in the first region M when the position of the fiducial mark (F-mark 55) is not detected (S14: No) by scanning in the detection step (S13).

According to such a configuration, when the position of the F-mark 55 of the board 50 cannot be detected (S14 : No), the reference position of the board 50 is recognized by using the second template 80 that shows the other distinctive portion 53 included in the same first region M. Thus, the complementary process (S15, S115) that uses the second template 80 can be executed, and the reference position can be recognized with higher accuracy than setting the reference position of the board 50 by manual manipulation of the operator (S16). Further, the acquired image data 60 using the first template 70 can be redirected for use in the initial detection process (S13) . As a result, the processing efficiency in the image processing can be improved, and the time required for the complementary process (S15, S115) can be shortened.

In addition, in the first and second embodiments, the image processing device 30 includes a display unit (display device 23) that displays the acquired second template 80 superimposed on the image data 60 and a setting receiving unit (input device 24) that receives the setting of the relative position of the second template 80 with respect to the image data 60. The position recognition unit 35 recognizes the reference position of the board 50 based on the content of the setting (S30) and the positional relationship with the reference position defined in the second template 80 (S16).

According to such a configuration, the reference position of the board 50 can be recognized by reflecting the content of the setting input by the operator. Here, for example, when a template is superimposed on the image data 60 and the setting of the reference position by manual operation is received, the operator performs an operation to align the template with the F-mark 55. However, the F-mark 55 is not detectable by the image processing device 30 due to a factor such as a lack of a portion of the F-mark 55, and it is not easy for the operator to accurately perform alignment by visual measurement.

In contrast, according to the above-described configuration, assisting the operator in manual alignment is possible since the second template 80 positioned around the F-mark 55 is displayed on the image data 60 so as to be superimposed on the image data 60. Therefore, even when the setting is performed by visual measurement of the operator, the relative position of the second template 80 with respect to the image data 60 can be more accurately set than aligning the F-mark 55 with the second template 80. As a result, the reference position can be recognized with high accuracy.

In the first and second embodiments, when the second template 80 is superimposed on the image data 60 and displayed, the display unit (i.e., the display device 23) also displays the degree of matching based on the relative position of the second template 80 with respect to the distinctive portion 53 of the board 50.

According to such a configuration, the operator can set the relative position of the second template 80 with respect to the image data 60 with reference to the displayed degree of matching (S32). As a result, since the current state can be always known in addition to the visual observation of the shape, the relative position can be set with higher accuracy. Therefore, the reference position of the board 50 can be recognized with high accuracy.

In the second embodiment, the detection unit 32 scans the image data 60 using the acquired second template 80 to detect the position of the distinctive portion 53 (S142). The position recognition unit 35 recognizes the reference position of the board 50 based on the detection result by the detection unit 32 and the positional relationship with the reference position defined in the second template 80 (S16) .

According to this configuration, the detection unit 32 (S142) re-scans the image data 60 using the second template 80 that can be used in the same first region M. As a result, the operator omits manual operations such as aligning the template with respect to the image data 60 (S143: Yes), and the reference position of the board 50 is automatically recognized (S16). Therefore, the processing efficiency in the image processing can be improved, and the time required for the complementary processing (S115) can be shortened.

In addition, in the first and second embodiments, the image processing device 30 is applied to the component mounting machine 10 that mounts a plurality of electronic components on the board 50 and performs a recognition process for recognizing a reference position during multiple executions of the mounting process by the component mounting machine 10. When the position of the reference mark (F-mark 55) is not detected by scanning using the first template 70 of the detection unit 32 in the second and subsequent recognition processes, the template acquisition unit 33 acquires the first image data 60, which is the image data 60 used in the previous recognition process in which the position of the fiducial mark (F-mark 55) is detected (S22), and executes image processing for making the first image data 60 transparent or image processing for extracting the edge corresponding to the distinctive portion 53 to generate the second template 80 (S23).

According to such a configuration, the second template 80 is generated from the first image data 60 that was used in the past rather than the current detection process and in which the fiduciary mark (F-mark 55) was successfully detected. Thus, for example, as compared with the case where the second template 80 is generated based on the image data 60 obtained by imaging the other board 50 of the same type, the second template 80 can be generated which is suitable for detecting the distinctive portion 53 by reflecting a state unique to the board 50 (i.e., the state of the wiring pattern, the state of the solder printing, and the state of the mounted electronic component).

In addition, in the first and second embodiments, in the generation process (S23) for generating the second template 80, the template acquisition unit 33 executes image processing for removing a region including the fiducial mark (F-mark 55) in the first image data 60 (see FIG. 7).

According to such a configuration, the region including the fiducial mark (F-mark 55) is removed from the second template 80. Here, in the complementary process (S15, S115), the fiducial mark (F-mark 55) is not detectable by the image processing device 30 due to a factor such as a lack of a portion of the F-mark 55, for example. Therefore, if the second template 80 includes a region including the fiducial mark (F-mark 55), there is a possibility that processes such as subsequent scanning and aligning may be affected. Therefore, with the above-described configuration, it is possible to remove inconsistent regions in advance and adapt the second template 80 with the complementary process (S15, S115).

In addition, in the first and second embodiments, in the generation process (S23) for generating the second template 80, the template acquisition unit 33 divides the first image data 60 into a plurality of sections 61, and executes image processing for removing the section 61R on which the electronic component is mounted from the plurality of sections 61 or the section 61R in which the complexity of the image exceeds a predetermined threshold value (see FIG. 7) .

With such a configuration, the section 61R is specifically removed from the second template 80. Here, the first image data 60 that has been used in the previous detection process and has successfully detected the F-mark 55 includes a region in which a state unique to the board 50 (e.g., the state of the mounted electronic component) varies depending on the subsequent execution of the mounting process and the first image data 60 cannot be used as the distinctive portion 53 in the complementary process (S15, S115). In addition, when the complexity of an image exceeds a certain level due to having many outline lines, the template tends to be unsuitable for scanning and aligning. Therefore, the second template 80 can be adapted by the complementary process (S15, S115) by removing sections in which the state unique to the board varies and the sections in which the complexity of the image exceeds a certain level.

### Variations of the First and Second Embodiments

In the first and second embodiments, the fiducial mark disposed on the upper surface of the board 50 is the F-mark 55. On the other hand, the image processing device 30 may adopt a distinctive portion of the board 50, such as a portion of the wiring pattern of the board 50, as a fiducial mark. This is applied, for example, when the F-mark 55 is omitted to increase the density of the board 50, or when the positional relationship between the F-mark 55 and the wiring pattern is not constant due to the structure of the board 50.

In the aspect described above, a portion of the plurality of distinctive portions included in the first region M is used as a fiducial mark. When the position of the fiducial mark is not detected, another portion of the plurality of distinctive portions included in the first area M is detected in the complementary process (S 15, S115). In such a configuration, the same effects as those of the first and second embodiments are obtained.

In the first and second embodiments, the image processing device 30 is applied to the control device 20 of the component mounting machine 10. On the other hand, the image processing device and the image processing method for a board can be applied to other production facilities such as a screen printer, a mounting inspector, or the host computer 2. In such a configuration, the same effects as those of the first and second embodiments are obtained.

### DESCRIPTION OF SYMBOLS

1: production line, 2: host computer, 10: component mounting machine, 11: board conveyance device, 12: component supply device, 12a: feeder, 13: component transfer device, 13a: head driving device, 13b: moving table, 13c : mounting head, 14: component camera, 15: board camera, 20: control device, 21: mounting control unit, 22: storage device, 23: display device (display unit), 24: input device (setting receiving unit), 32: detection unit 33: template acquisition unit, 35: position recognition unit, 50: board, 51: land, 52: wiring portion, 53: distinctive portion, 55: fiducial mark (F-mark), 60: image data, 60B: image data (in which F-mark is successfully detected) (first image data), 61: section, 61R: section to be removed, 70: first template, 71: seek line, 72: defining point (of the first template), 80: second template, 81: standard line, 82: defining point (of the second template), M: first region, Ps: supply position

## Claims

1. An image processing device (30) for a board (50) comprising:
an image acquisition unit (31) that is configured to acquire image data (60) by capturing an image of a first region (M) including a fiducial mark (55) disposed on an upper surface of the board (50);
a detection unit (32) that is configured to scan the image data (60) using a first template (70) indicating a shape of the fiducial mark (55) to detect a position of the fiducial mark (55), wherein the positional relationship of the first template (70) with a reference position of the board (50) is known;
a template acquisition unit (33) that is configured to newly generate a second template (80) or acquire an existing second template (80) already generated in another board, wherein the second template (80) indicates a distinctive portion (53) of the board (50) located outside the fiducial mark (55) in the first region (M), when the position of the fiducial mark (55) is not detected by scanning with the detection unit (32); and
a position recognition unit (35) that is configured to recognize the reference position of the board (50) based on the detection of the position of the fiducial mark (55) and is configured to recognize the reference position of the board (50) using the second template (80), when the position of the fiducial mark (55) is not detected by scanning with the detection unit (32),
wherein
a display unit (23) is configured to display the acquired second template (80) superimposed on the image data (60), and
a setting receiving unit (24) is configured to receive a setting of a relative position of the second template (80) with respect to the image data (60), wherein
the position recognition unit (35) recognizes the reference position of the board (50) based on content of the setting and a known positional relationship of the second template (80) with the reference position of the board (50);
the image processing device (30) being further configured to be applied to a component mounting machine (10) that mounts a plurality of electronic components on the board (50), and to execute the recognition process for recognizing the reference position a plurality of times during execution of the mounting process by the component mounting machine (10),
wherein the template acquisition unit (33) is further configured to acquire first image data (60B), which is the image data used in the previous recognition process in which a position of the fiducial mark (55) was detected, and to execute image processing for making the first image data (60B) transparent so that other image data displayed with the second template can be viewed or image processing for extracting an edge corresponding to the distinctive portion (53) to generate the second template (80);
wherein the template acquisition unit (33) is further configured to execute image processing for removing a region including the fiducial mark (55) in the first image data (60B) in the generation process for generating the second template (80).

2. The image processing device (30) for a board (50) according to claim 1, wherein
the display unit (23) is configured to display a degree of matching based on the relative position of the second template (80) with respect to the distinctive portion (53) of the board (50) together when the second template (80) is displayed in an overlapping manner on the image data (60).

3. The image processing device (30) for a board (50) according to claim 1 or 2, wherein
the detection unit (32) is configured to scan the image data (60) using the acquired second template (80) to detect a position of the distinctive portion (53), and the position recognition unit (35) is configured to recognize the reference position of the board (50) based on a result of detection by the detection unit (32) and a known positional relationship of the second template (80) with the reference position of the board (50).

4. The image processing device (30) for a board (50) according to claim 1, wherein
the template acquisition unit (33) is configured to divide the first image data (60B) into a plurality of sections (61) and is configured to execute image processing for removing a section (61) in which an electronic component is mounted or a section (61) in which the number of outline lines of the image exceeds a predetermined threshold value from the plurality of sections (61) in the generation process for generating the second template (80).

5. An image processing method for a board (50) comprising:
acquiring image data (60) obtained by capturing an image of a first region (M) that includes a fiduciary mark disposed on an upper surface of the board (50);
scanning the image data (60) using a first template (70) showing a shape of the fiduciary mark to detect a position of the fiduciary mark (55), wherein the positional relationship of the first template (70) with the reference position of the board (50) is known;
generating a new second template or acquiring an existing second template (80) already generated in another board, wherein the second template (80) indicates a distinctive portion (53) of the board (50) located outside the fiduciary mark in the first region (M), in case of the position of the fiduciary mark being not detected by scanning; and
recognizing the reference position of the board (50) based on the detection result of the position of the fiduciary mark (55) and recognizing the reference position of the board (50) using the second template (80), when the position of the fiduciary mark (55) is not detected by scanning, and
displaying the acquired second template (80) superimposed on the image data (60), and
receiving a setting of a relative position of the second template (80) with respect to the image data (60), and
recognizing the reference position of the board (50) based on content of the setting and a known positional relationship of the second template (80) with the reference position of the board (50), wherein
the image processing method for a board 50) further includes:
mounting a plurality of electronic components on the board (50), recognizing the reference position a plurality of times during execution of the mounting process by the component mounting machine (10),
acquiring a first image data (60B), which is the image data used in the previous recognition process in which a position of the fiduciary mark (55) was detected, and to execute image processing for making the first image data (60B) transparent so that other image data displayed with the second template can be viewed or image processing for extracting an edge corresponding to the distinctive portion (53) to generate the second template (80);
wherein the image processing further comprises executing image processing for removing a region including the fiduciary mark (55) in the first image data (60B) in the generation process for generating the second template (80).

## Patentansprüche

1. Bildverarbeitungsvorrichtung (30) für eine Leiterplatte (50), umfassend:
eine Bilderfassungseinheit (31), die dazu konfiguriert ist, Bilddaten (60) durch Aufnehmen eines Bildes eines ersten Bereichs (M) einschließlich einer Bezugsmarkierung (55) zu erfassen, die auf einer Oberseite der Leiterplatte (50) angeordnet ist;
eine Ermittlungseinheit (32), die dazu konfiguriert ist, die Bilddaten (60) unter Verwendung einer ersten Schablone (70) abzutasten, welche eine Form der Bezugsmarkierung (55) anzeigt, um eine Position der Bezugsmarkierung (55) zu ermitteln, wobei die Positionsbeziehung der ersten Schablone (70) zu einer Referenzposition der Leiterplatte (50) bekannt ist;
eine Schablonenerfassungseinheit (33), die dazu konfiguriert ist, eine zweite Schablone (80) neu zu erzeugen oder eine vorhandene zweite Schablone (80) zu erfassen, die bereits in einer anderen Leiterplatte erzeugt wurde, wobei die zweite Schablone (80) einen bestimmten Abschnitt (53) der Leiterplatte (50) anzeigt, der sich außerhalb der Bezugsmarkierung (55) in dem ersten Bereich (M) befindet, wenn die Position der Bezugsmarkierung (55) durch Abtasten mit der Ermittlungseinheit (32) nicht ermittelt wird;
eine Positionserkennungseinheit (35), die dazu konfiguriert ist, die Referenzposition der Leiterplatte (50) basierend auf der Ermittlung der Position der Bezugsmarkierung (55) zu erkennen, und dazu konfiguriert ist, die Referenzposition der Leiterplatte (50) unter Verwendung der zweiten Schablone (80) zu erkennen, wenn die Position der Bezugsmarkierung (55) durch Abtasten mit der Ermittlungseinheit (32) nicht ermittelt wird,
wobei
eine Anzeigeeinheit (23) dazu konfiguriert ist, die erfasste zweite Schablone (80) überlagert auf den Bilddaten (60) anzuzeigen, und
eine Einstellungsempfangseinheit (24) dazu konfiguriert ist, eine Einstellung einer relativen Position der zweiten Schablone (80) bezüglich der Bilddaten (60) zu empfangen,
wobei
die Positionserkennungseinheit (35) die Referenzposition der Leiterplatte (50) basierend auf Inhalt der Einstellung und einer bekannten Positionsbeziehung der zweiten Schablone (80) zu der Referenzposition der Leiterplatte (50) erkennt;
wobei die Bildverarbeitungsvorrichtung (30) des Weiteren dazu konfiguriert ist, auf eine Komponentenmontagemaschine (10) angewendet zu werden, die eine Vielzahl von elektronischen Komponenten auf der Leiterplatte (50) montiert, und den Erkennungsprozess zum Erkennen der Referenzposition eine Vielzahl von Malen während der Ausführung des Montageprozesses durch die Komponentenmontagemaschine (10) auszuführen,
wobei die Schablonenerfassungseinheit (33) des Weiteren dazu konfiguriert ist, erste Bilddaten (60B) zu erfassen, bei welchen es sich um die Bilddaten handelt, die in dem vorhergehenden Erkennungsprozess verwendet wurden, in welchem eine Position der Bezugsmarkierung (55) ermittelt wurde, und die Bildverarbeitung auszuführen, um die ersten Bilddaten (60B) transparent zu machen, so dass weitere Bilddaten, die mit der zweiten Schablone angezeigt werden, betrachtet werden können, oder die Bildverarbeitung zum Extrahieren einer Kante entsprechend dem bestimmten Abschnitt (53) auszuführen, um die zweite Schablone (80) zu erzeugen;
wobei
die Schablonenerfassungseinheit (33) des Weiteren dazu konfiguriert ist, die Bildverarbeitung zum Entfernen eines Bereiches einschließlich der Bezugsmarkierung (55) in den ersten Bilddaten (60B) in dem Erzeugungsprozess zum Erzeugen der zweiten Schablone (80) auszuführen.

2. Bildverarbeitungsvorrichtung (30) für eine Leiterplatte (50) nach Anspruch 1, wobei
die Anzeigeeinheit (23) dazu konfiguriert ist, einen Übereinstimmungsgrad basierend auf der relativen Position der zweiten Schablone (80) bezüglich dem bestimmten Abschnitt (53) der Leiterplatte (50) zusammen anzuzeigen, wenn die zweite Schablone (80) in überlappender Weise auf den Bilddaten (60) angezeigt wird.

3. Bildverarbeitungsvorrichtung (30) für eine Leiterplatte (50) nach Anspruch 1 oder 2, wobei
die Ermittlungseinheit (32) dazu konfiguriert ist, die Bilddaten (60) unter Verwendung der erfassten zweiten Schablone (80) abzutasten, um eine Position des bestimmten Abschnitts (53) zu ermitteln, und die Positionserkennungseinheit (35) dazu konfiguriert ist, die Referenzposition der Leiterplatte (50) basierend auf einem Ermittlungsergebnis durch die Ermittlungseinheit (32) und einer bekannten Positionsbeziehung der zweiten Schablone (80) zu der Referenzposition der Leiterplatte (50) zu erkennen.

4. Bildverarbeitungsvorrichtung (30) für eine Leiterplatte (50) nach Anspruch 1, wobei
die Schablonenerfassungseinheit (33) dazu konfiguriert ist, die ersten Bilddaten (60B) in eine Vielzahl von Abschnitten (61) aufzuteilen und dazu konfiguriert ist, die Bildverarbeitung zum Entfernen eines Abschnitts (61), in dem eine elektronische Komponente montiert ist, oder eines Abschnitts (61), in dem die Anzahl von Umrisslinien des Bildes einen vorgegebenen Schwellenwert überschreitet, aus der Vielzahl von Abschnitten (61) in dem Erzeugungsprozess zum Erzeugen der zweiten Schablone (80) auszuführen.

5. Bildverarbeitungsverfahren für eine Leiterplatte (50), umfassend:
Erfassen von Bilddaten (60), die durch Aufnehmen eines Bildes eines ersten Bereiches (M) erhalten werden, der eine Bezugsmarkierung enthält, die auf einer Oberseite der Leiterplatte (50) angeordnet ist;
Abtasten der Bilddaten (60) unter Verwendung einer ersten Schablone (70), welche eine Form der Bezugsmarkierung zeigt, um eine Position der Bezugsmarkierung (55) zu ermitteln, wobei die Positionsbeziehung der ersten Schablone (70) zu der Referenzposition der Leiterplatte (50) bekannt ist;
Erzeugen einer neuen zweiten Schablone oder Erfassen einer vorhandenen zweiten Schablone (80), die bereits in einer anderen Leiterplatte erzeugt wurde, wobei die zweite Schablone (80) einen bestimmten Abschnitt (53) der Leiterplatte (50) anzeigt, der sich außerhalb der Bezugsmarkierung in dem ersten Bereich (M) befindet, falls die Position der Bezugsmarkierung durch Abtasten nicht ermittelt wird; und
Erkennen der Referenzposition der Leiterplatte (50) basierend auf dem Ermittlungsergebnis der Position der Bezugsmarkierung (55) und Erkennen der Referenzposition der Leiterplatte (50) unter Verwendung der zweiten Schablone (80), wenn die Position der Bezugsmarkierung (55) durch Abtasten nicht ermittelt wird, und
Anzeigen der erfassten zweiten Schablone (80) überlagert auf den Bilddaten (60), und
Empfangen einer Einstellung einer relativen Position der zweiten Schablone (80) bezüglich der Bilddaten (60), und
Erkennen der Referenzposition der Leiterplatte (50) basierend auf Inhalt der Einstellung und einer bekannten Positionsbeziehung der zweiten Schablone (80) zu der Referenzposition der Leiterplatte (50), wobei
das Bildverarbeitungsverfahren für eine Leiterplatte (50) des Weiteren beinhaltet:
Montieren einer Vielzahl von elektronischen Komponenten auf der Leiterplatte (50), Erkennen der Referenzposition eine Vielzahl von Malen während der Ausführung des Montageprozesses durch die Komponentenmontagemaschine (10),
Erfassen von ersten Bilddaten (60B), bei welchen es sich um die Bilddaten handelt, die in dem vorhergehenden Erkennungsprozess verwendet wurden, in welchem eine Position der Bezugsmarkierung (55) ermittelt wurde, und die Bildverarbeitung auszuführen, um die ersten Bilddaten (60B) transparent zu machen, so dass weitere Bilddaten, die mit der zweiten Schablone angezeigt werden, betrachtet werden können, oder die Bildverarbeitung zum Extrahieren einer Kante entsprechend dem bestimmten Abschnitt (53), um die zweite Schablone (80) zu erzeugen;
wobei die Bildverarbeitung des Weiteren umfasst:
Ausführen der Bildverarbeitung zum Entfernen eines Bereiches einschließlich der Bezugsmarkierung (55) in den ersten Bilddaten (60B) in dem Erzeugungsprozess zum Erzeugen der zweiten Schablone (80).

## Revendications

1. Dispositif de traitement d'images (30) pour une carte (50) comprenant:
une unité d'acquisition d'image (31) qui est configurée pour acquérir des données d'image (60) en capturant une image d'une première zone (M) comprenant une marque de repère (55) disposée sur une surface supérieure de la carte (50) ;
une unité de détection (32) qui est configurée pour scanner les données d'image (60) en utilisant un premier gabarit (70) indiquant une forme de la marque de repère (55) pour détecter une position de la marque de repère (55), dans laquelle la relation de position du premier gabarit (70) avec une position de référence de la carte (50) est connue;
une unité d'acquisition de gabarit (33) qui est configurée pour générer un nouveau gabarit (80) ou acquérir un second gabarit (80) déjà généré dans une autre carte,
dans lequel le second gabarit (80) indique une partie distinctive (53) de la carte (50) située à l'extérieur de la marque de repère (55) dans la première zone (M), lorsque la position de la marque de repère (55) n'est pas détectée par balayage avec l'unité de détection (32);
une unité de reconnaissance de position (35) qui est configurée pour reconnaître la position de référence de la carte (50) sur la base de la détection de la position de la marque de repère (55) et est configurée pour reconnaître la position de référence de la carte (50) en utilisant le second gabarit (80), lorsque la position de la marque de repère (55) n'est pas détectée par balayage avec l'unité de détection (32),
dans lequel une unité d'affichage (23) est configurée pour afficher le second gabarit acquis (80) superposé aux données d'image (60), et
une unité de réception de réglage (24) est configurée pour recevoir un réglage d'une position relative du second gabarit (80) par rapport aux données d'image (60), dans laquelle
l'unité de reconnaissance de la position (35) reconnaît la position de référence de la carte (50) sur la base du contenu de la trame et d'une relation positionnelle connue du second gabarit (80) avec la position de référence de la carte (50):
le dispositif de traitement d'images (30) étant en outre configuré pour être appliqué à une machine de montage de composants (10) qui monte une pluralité de composants électroniques sur la carte (50) et pour exécuter le processus de reconnaissance afin de reconnaître la position de référence une pluralité de fois pendant l'exécution du processus de montage par la machine de montage de composants (10),
dans lequel l'unité d'acquisition de gabarit (33) est en outre configurée pour acquérir des premières données d'image (60B), qui sont les données d'image utilisées dans le processus de reconnaissance précédent dans lequel une position de la marque de repère (55) a été détectée, et pour exécuter un traitement d'images pour rendre les premières données d'image (60B) transparentes de sorte que d'autres données d'image affichées avec le second gabarit puissent être visualisées ou un traitement d'images pour extraire un bord correspondant à la partie distinctive (53) pour générer le second gabarit (80);
dans lequel l'unité d'acquisition de gabarit (33) est en outre configurée pour exécuter un traitement d'images pour supprimer une zone comprenant la marque de repère (55) dans les premières données d'image (60B) dans le processus de génération pour générer le second gabarit (80).

2. Dispositif de traitement d'images (30) pour une carte (50) selon la revendication 1, dans lequel
l'unité d'affichage (23) est configurée pour afficher un degré de correspondance fondé sur la position relative du second gabarit (80) par rapport à la partie distinctive (53) de la carte (50) lorsque le second gabarit (80) est affiché de manière à recouvrir les données d'image (60).

3. Dispositif de traitement d'images (30) pour une carte (50) selon les revendications 1 ou 2, dans lequel
l'unité de détection (32) est configurée pour scanner les données d'image (60) en utilisant le second gabarit acquis (80) pour détecter une position de la partie distinctive (53), et l'unité de reconnaissance de position (35) est configurée pour reconnaître la position de référence de la carte (50) sur la base d'un résultat de détection par l'unité de détection (32) et d'une relation de position connue du second gabarit (80) avec la position de référence de la carte (50).

4. Dispositif de traitement d'images (30) pour une carte (50) selon la revendication 1, dans lequel
l'unité d'acquisition de gabarit (33) est configurée pour diviser les premières données d'image (60B) en une pluralité de sections (61) et est configurée pour exécuter un traitement d'images pour supprimer une section (61) dans laquelle un composant électronique est prévu ou une section (61) dans laquelle le nombre de lignes de contour de l'image dépasse une valeur seuil prédéterminée de la pluralité de sections (61) dans le processus de génération pour générer le second gabarit (80).

5. Procédé de traitement d'images pour une carte (50) comprenant:
l'acquisition de données d'image (60) obtenues en capturant une image d'une première zone (M) qui comprend une marque de repère disposée sur une surface supérieure de la carte (50);
le balayage des données d'image (60) en utilisant un premier gabarit (70) montrant une forme de la marque de repère pour détecter une position de la marque de repère (55), dans lequel la relation de position du premier gabarit (70) avec la position de référence de la carte (50) est connue;
la génération d'un nouveau second gabarit ou l'acquisition d'un second gabarit existant (80) déjà généré dans une autre carte,
dans lequel le second gabarit (80) indique une partie distinctive (53) de la carte (50) située en dehors de la marque de repère dans la première zone (M), dans le cas où la position de la marque de repère n'est pas détectée par balayage; et
la reconnaissance de la position de référence de la carte (50) sur la base du résultat de la détection de la position de la marque de repère (55) et reconnaître la position de référence de la carte (50) en utilisant le second gabarit (80), lorsque la position de la marque de repère (55) n'est pas détectée par balayage, et
l'affichage du second gabarit acquis (80) superposé aux données de l'image (60),
et
la réception d'un réglage d'une position relative du second gabarit (80) par rapport aux données d'image (60), et
la reconnaissance de la position de référence de la carte (50) sur la base du contenu de la trame et d'une relation de position connue du second gabarit (80) avec la position de référence de la carte (50),
dans lequel
le procédé de traitement d'images pour une carte (50) comprend en outre:
le montage d'une pluralité de composants électroniques sur la carte (50), en reconnaissant la position de référence une pluralité de fois pendant l'exécution du processus de montage par la machine de montage de composants (10),
l'acquisition d'une première donnée d'image (60B), qui est la donnée d'image utilisée dans le processus de reconnaissance précédent dans lequel une position de la marque de repère (55) a été détectée, et
l'exécution d'un traitement d'images pour rendre la première donnée d'image (60B) transparente afin que d'autres données d'image affichées avec le second gabarit puissent être visualisées ou un traitement d'images pour extraire un bord correspondant à la partie distinctive (53) pour générer le second gabarit (80);
dans lequel le traitement d'images comprend en outre
l'exécution d'un traitement d'images pour supprimer une zone comprenant la marque de repère (55) dans les premières données d'image (60B) dans le processus de génération pour générer le second gabarit (80).
